# EUROPÄISCHE PATENTANMELDUNG

(11) **EP 0 677 897 A2**
(43) Veröffentlichungstag der Anmeldung: **18.10.1995**
(21) Anmeldenummer: 95103079.0
(22) Anmeldetag: 03.03.1995
(51) Int. Cl.: H01R 23/68

(54) **Leiterplattenanordnung für Steckverbindungen**

(30) Priorität: 14.04.1994 DE 4412974
(71) Anmelder: SIEMENS AKTIENGESELLSCHAFT, D-80333 München (DE)
(72) Erfinder: Zell, Karl, Dipl.-Ing., D-82343 Niederpöcking (DE); Seibold, Jürgen, Dipl.-Ing., D-82065 Baierbrunn (DE); Seidel, Peter, D-82194 Gröbenzell (DE)

(57) **Zusammenfassung**

Die Erfindung betrifft eine Leiterplattenanordnung für Steckverbindungen bestehend aus Messerleiste und Federleiste, wobei die einzelnen Kontaktdurchgänge von elektrisch leitfähigen Schirmblechen umgeben sind, welche mit im Zwischenraster sowohl rückwandseitig als auch baugruppenseitig angebrachten Schirmpotential führenden Kontaktierungen verbunden sind, und wobei sowohl die Kontaktmesser und Kontaktfedern als auch die Kontaktierungen mittels Einpreßtechnik in den als mehrlagigen Multilayer ausgebildeten Leiterplatten kontaktiert und befestigt sind.

Um zwischen den Kontaktierungen eine ausreichende Leiterbahndurchführungsbreite zu schaffen, ohne teure Multilayer zu benötigen, wird bei der erfindungsgemäßen Leiterplattenanordnung das Schirmpotential in einer von dem Multilayer (1) durch eine Insolierfolie (2) elektrisch getrennten separaten Schirmungsleiterplatte (3) geführt.

## Beschreibung

Die vorliegende Erfindung betrifft eine Leiterplattenanordnung für Steckverbindungen zwischen Rückwandleiterplatten und Baugruppenleiterplatten, wobei die Steckverbindung aus einer als einseitig offenes rechtwinkliges Gehäuse ausgebildeten Messerleiste zum Aufstecken auf die Messer einer Rückwandleiterplatte und einer in die Messerleiste einsteckbaren mit Kontaktfedern bestückten Aufnahmekammern versehenen und mit einer Baugruppenleiterplatte fest verbundenen Federleiste, wobei die Messer und Federn parallel in mehreren Reihen angeordnet sind, wobei die einzelnen Kontaktdurchgänge von elektrisch leitfähigen Schirmblechen umgeben sind, welche mit im Zwischenraster sowohl rückwandseitig als auch baugruppenseitig angebrachten Schirmpotential führenden Kontaktierungen verbunden sind, die mit einem entsprechenden Potential beaufschlagt sind, und wobei sowohl die Kontaktmesser und Kontaktfedern als auch die Kontaktierungen mittels Einpreßtechnik in den als mehrlagige Multilayer ausgebildeten Leiterplatten kontaktiert und befestigt sind.

Ein Steckverbinder für Rückwandverdrahtungen, bei welchem eine Schirmung, wie oben angegeben, im Zwischenraster erfolgt, ist z.B. in der europäischen Patentanmeldung 94 103 192 vorgeschlagen worden. Bei derartigen Steckverbinderanordnungen ist zum Teil der Nachteil vorhanden, daß zwischen den Kontaktmessern und den im Zwischenraster angeordneten Schirmkontaktierungen eine zu geringe Leiterbahndurchführungsbreite auf den Leiterplatten gegeben ist. Dies hat zur Folge, daß der Multilayer zusätzliche Lagen benötigt und damit teurer wird.

Die Aufgabe der vorliegenden Erfindung besteht daher darin, eine Leiterplattenanordnung der eingangs genannten Art zu schaffen, bei der eine ausreichende Leiterbahndurchführungsbreite gegeben ist und die keine teuren Multilayer benötigt.

Diese Aufgabe wird für die obengenannte Leiterplattenanordnung gemäß der vorliegenden Erfindung dadurch gelöst, daß das Schirmpotential einer von dem Multilayer durch eine Isolierfolie elektrisch getrennten separaten Schirmungsleiterplatte geführt wird.

Bei der erfindungsgemäßen Leiterplatte wird das zusätzliche Schirmungspotential aus dem Multilayer eliminiert und in einer durch eine Folie elektrisch getrennten separaten Schirmungsleiterplatte geführt.

Eine zweckmäßige Ausgestaltung der erfindungsgemäßen Leiterplattenanordnung ist dadurch gekennzeichnet, daß die Dicke der Schirmungsleiterplatte derart bemessen ist, daß ein Stift in die Schirmungsleiterplatte einpressbar ist, ohne auf der unteren Seite überzustehen.

Hierdurch steht dem Multilayer wieder eine größtmögliche Leiterbahndurchführung zur Verfügung und daß z.B. über die Baugruppenfederleiste abgeleitete Erdpotential kann trotzdem der Backplain zugeordnet werden. Da darüberhinaus bei dieser Anordnung Kontaktmesser, die bisher mit Erdpotential belegt waren, für Signale frei werden, können Steckverbinder verkleinert und auf den Leiterplatten verteilt angeordnet werden, wodurch auch eine indirekte Codierung innerhalb eines Baugruppenrahmens möglich ist. Ebenso ist durch diese Steckerverkleinerung eine kleinere Leiterplattengröße möglich, was wiederum deren Kosten erheblich reduziert.

Eine andere zweckmäßige Ausgestaltung der erfindungsgemäßen Leiterplattenanordnung ist dadurch gekennzeichnet, daß die Schirmkontaktierungen nur in partiellen Bereichen der Leiterplatte erfolgen.

Durch die partielle Anordnung der Schirmkontaktierungen läßt sich die Leiterplattengröße auf ein Minimum verkleinern und die Schirmungsableitung muß nur dort eingesetzt werden, wo sie gebraucht wird. Die Erdableitung bzw. die Schirmungsableitung kann dann vom Entwickler an eine unkritische Stelle gesetzt werden.

Weitere Ausgestaltungen des erfindungsgemäßen Steckverbinders ergeben sich aus den weiteren Unteransprüchen sowie aus der nachfolgenden Beschreibung eines Ausführungsbeispiels anhand der Figur.

Es zeigen
- Fig. 1: teilweise Querschnitte durch eine Leiterplattenanordnung gemäß der vorliegenden Erfindung,
- Fig. 2: einen teilweisen Schnitt durch die in Fig. 1 gekennzeichnete Ebene E1,
- Fig. 3: einen teilweisen Schnitt durch die in Fig. 1 gekennzeichnete Ebene E2,
- Fig. 4: einen Schnitt durch die in Fig. 1 gekennzeichnete Ebene E3.

Die erfindungsgemäße Leiterplattenanordnung besteht im wesentlichen aus dem Multilayer, d.h. der Signalleiterplatte 1, die Trägerin der Signalleiterbahnen ist. Von dem Multilayer 1 durch eine Isolierfolie 2 (Prepreg) getrennt ist die Schirmungsleiterplatte 3 angeordnet. Dabei ist die Leiterplattenanordnung so angeordnet, daß die Schirmungsleiterplatte 3 benachbart zur Steckverbindung (hier nicht gezeigt) liegt.

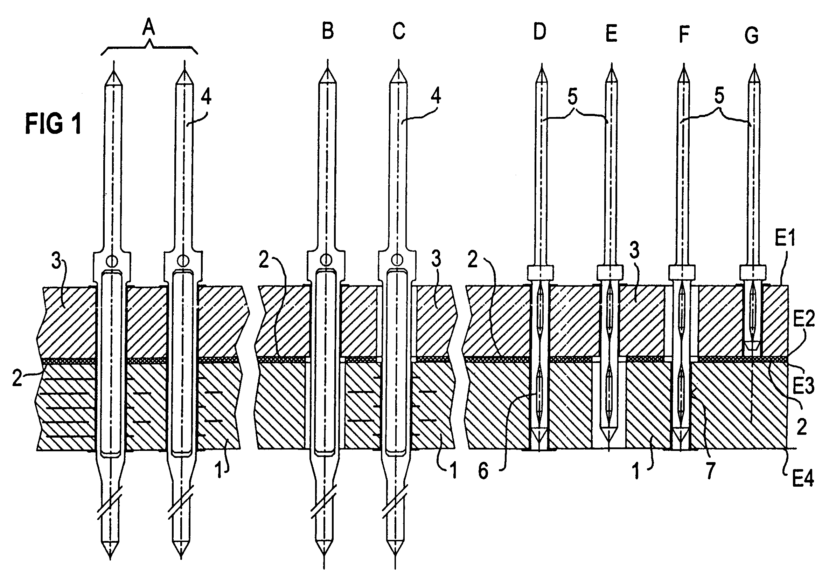

In der Fig. 1 sind einige mögliche Bestückungen der Leiterplattenanordnung dargestellt, wobei mit 4 die Kontaktmesser für die Leitung der Signale bezeichnet sind und mit 5 die Schirmkontaktierungen.

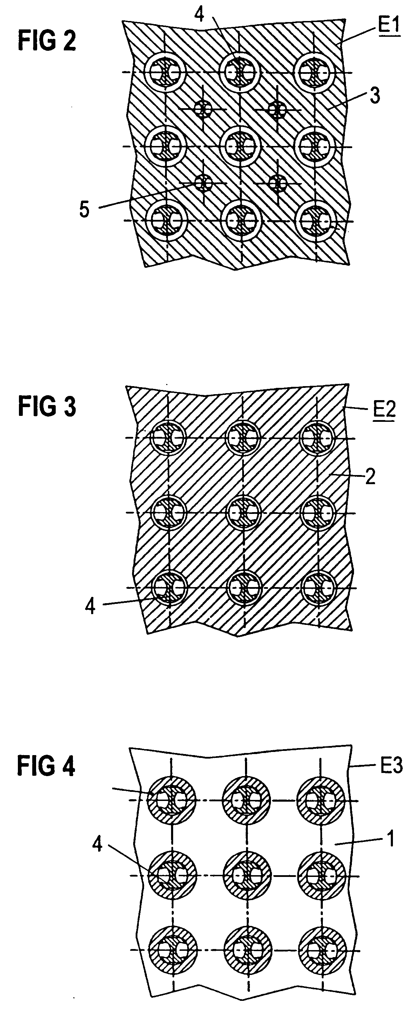

In Fig. 2 ist die Anordnung der Schirmkontaktierungen 5 im Zwischenraster zwischen den Kontaktmessern 4 zu erkennen.

Die Schirmungsleiterplatte 3 führt in der Ebene E1 und in der Ebene E2 Erdpotential. Die Dicke der Schirmungsleiterplatte ist derart bemessen, daß ein Stift in die Schirmungsleiterplatte 3 einpreßbar ist, ohne daß er auf der unteren Seite übersteht. Eine derartige Bestückung in der Fig. 1 mit G gekennzeichnet ist der Normalfall.

Fig. 2 zeigt eine Draufsicht auf die Ebene E1, d.h. auf die dem Steckverbinder zugewandten Oberfläche der Schirmungsleiterplatte 3. Die Fig. 3 zeigt eine Aufsicht auf die Ebene E2, d.h., eine Aufsicht auf die der Steckverbindung zugewandten Seite der Isolierfolie 2.

Fig. 4 zeigt eine Draufsicht auf die Ebene E3, d.h. auf die der Steckverbindung zugewandten Seite des Multilayers 1. Es ist im Zusammenhang mit Fig. 1 zu erkennen, daß die Figuren 2 bis 4 nur für den Fall der in Fig. 1 mit G gekennzeichneten Bestückung gilt.

Der erfindungsgemäßen Lösung liegt die Idee zugrunde, zusätzliches Erdpotential aus dem Multilayer 1 zu eliminieren und in einer durch eine Isolierfolie 2 elektrisch getrennten separaten Schirmungsleiterplatte 3 zu führen. Diese Platte ist so dick, daß die Schirmungskontaktierung mit ihrem Einpreßbereich darin eingepreßt werden kann, ohne unten überzustehen (Fall G). Hiermit steht dem Multilayer wieder eine größtmögliche Leiterbahndurchfuhrung (Gassenbreite) für die Signalleiterbahnen zur Verfügung und daß über die Steckverbindungen abgeleitete Schirmungspotential kann trotzdem den Leiterplatten zugeordnet werden.

Dort, wo die Steckverbinder Schirmungs- bzw. Erdpotential benötigen, kann das Kontaktmesser 4 beide Platten (Fall A) oder nur die Schirmungsleiterplatte 3 (Fall B) kontaktieren. Die Standardkontaktierung für das Kontaktmesser 4 ist die unter C gezeigte Anordnung, bei der das Kontaktmesser lediglich den Multilayer 1 kontaktiert.

Ebenso ist es möglich, daß die Schirmkontaktierungen durch unterschiedliche Einpreßzonen, bzw. durch unterschiedliche Bohrungen in der Leiterplattenanordnung sowohl beide Platten, d.h. den Multilayer 1 und die Schirmungsleiterplatte 3, kontaktieren (Fall D) oder nur die Schirmungsleiterplatte 3 (Fall E) oder in besonderen Fällen nur den Multilayer 1 (Fall F). Daher ist mit 6 in Fig. 1 eine durchgehende Verbindung zwischen der Schirmungsleiterplatte 3 und dem Multilayer 1 dargestellt und mit 7 eine Verbindung für das Schirmpotential mit dem Multilayer 1.

Durch eine partielle Anordnung der Erdstifte läßt sich die Leiterplattengröße der Schirmungsleiterplatte auf ein Minimum verkleinern und auch nur dort einsetzen, wo die Notwendigkeit dazu besteht. Die Schirmungsableitung kann dann an eine unkritische Stelle gesetzt werden und durch die Ausführungen des Falls A und D oder durch allgemeine Verbindungselemente erfolgen. Auch ist es mit der erfindungsgemäßen Leiterplattenanordnung möglich eine Verbesserung einer bestehenden Baugruppe, die eine EMV-Ableitung benötigt nachträglich mit einem Schirmungsleiterplattenstreifen mit Schirmkontaktierungen kurzer Einpreßzonen nachzurüsten.

Da bei der erfindungsgemäßen Leiterplattenanordnung in herkömmliche Baugruppenrahmen, die bisher mit Erdpotential belegten Messer für Signale frei werden, können Steckverbinder verkleinert und auf den Leiterplatten verteilt angeordnet werden, wodurch auch innerhalb eines Baugruppenrahmens eine indirekte Codierung möglich ist. Durch diese Steckerverkleinerung ist auch eine kleinere Leiterplattengröße möglich, was wiederum deren Kosten erheblich reduziert. Auch könnnen jetzt partielle Steckerteile mit einer EMV- bzw. Erdableitung versehen werden.

## Patentansprüche

1. Leiterplattenanordnung für Steckverbindungen zwischen Rückwandleiterplatten und Baugruppenleiterplatten, wobei die Steckverbindung aus einer als einseitig offenes rechtwinkliges Gehäuse ausgebildeten Messerleiste zum Aufstecken auf die Messer einer Rückwandleiterplatte und einer in die Messerleiste einsteckbaren mit Kontaktfedern bestückten Aufnahmekammern versehenen und mit einer Baugruppenleiterplatte fest verbundenen Federleiste, wobei die Messer und Federn parallel in mehreren Reihen angeordnet sind, wobei die einzelnen Kontaktdurchgänge von elektrisch leitfähigen Schirmblechen umgeben sind, welche mit im Zwischenraster sowohl rückwandseitig als auch baugruppenseitig angebrachten Schirmpotential führenden Kontaktierungen verbunden sind, die mit einem entsprechenden Potential beaufschlagt sind, und wobei sowohl die Kontaktmesser und Kontaktfedern als auch die Kontaktierungen mittels Einpreßtechnik in den als mehrlagige Multilayer ausgebildeten Leiterplatten kontaktiert und befestigt sind,
**dadurch gekennzeichnet,**
daß das Schirmpotential in einer von dem Multilayer (1) durch eine Isolierfolie (2) elektrisch getrennten separaten Schirmungsleiterplatte (3) geführt wird.

2. Leiterplattenanordnung nach Anspruch 1,
**dadurch gekennzeichnet,**
daß die Dicke der Schirmungsleiterplatte (3) derart bemessen ist, daß ein Stift (5) in die Schirmungsleiterplatte einpreßbar ist, ohne auf der unteren Seite überzustehen.

3. Leiterplattenanordnung nach Anspruch 1,
**dadurch gekennzeichnet,**
daß die Einpreßzonen der Kontaktmesser (4) und die jeweiligen Bohrungen im Multilayer (1) und in der Schirmungsleiterplatte (3) derart ausgeführt sind, daß die Kontaktmesser (4) einzelne Platten (1 oder 3) oder beide Platten (1, 3) kontaktieren.

4. Leiterplattenanordnung nach Anspruch 1,
**dadurch gekennzeichnet,**
daß die Einpreßzonen der schirmpotentialführenden Kontaktierungen (5) und die jeweiligen Bohrungen im Multilayer (1) und in der Schirmungsleiterplatte (3) derart ausgeführt sind, daß die schirmpotentialführenden Kontaktierungen (5) einzelne Platten (1 oder 3) oder beide Platten (1, 3) kontaktieren.

5. Leiterplattenanordnung nach einem der vorhergehenden Ansprüche,
**dadurch gekennzeichnet,**
daß die Schirmkontaktierungen (5) einschließlich der zugehörigen Schirmungsleiterplatte (3) nur in partiellen Bereichen der Leiterplattenanordnung erfolgen.
